(19) Europäisches Patentamt
European Patent Office
Office européen des brevets

(11) **EP 1 361 613 B1**

(12) **FASCICULE DE BREVET EUROPEEN**

(45) Date de publication et mention
de la délivrance du brevet:
**26.03.2008 Bulletin 2008/13**

(51) Int Cl.:
*H01L 27/144* (2006.01)    *H04B 10/158* (2006.01)
*H04N 3/15* (2006.01)

(21) Numéro de dépôt: **03291029.1**

(22) Date de dépôt: **28.04.2003**

(54) **Cellule de photodétection et détecteur d'impulsion laser muni d'une telle cellule, ainsi que dispositif de détection d'impulsion laser comprenant une matrice de tels détecteurs**

Fotoempfangende Vorrichtung, Laserimpulsdetektor mit einer solchen Vorrichtung und Laserimpulsdetektorvorrichtung mit solchen Laserimpulsdetektoren

Photodetecting device, laser pulse detector comprising such device and a laser pulse detecting device comprising such laser pulse detectors

(84) Etats contractants désignés:
**AT BE BG CH CY CZ DE DK EE ES FI FR GB GR HU IE IT LI LU MC NL PT RO SE SI SK TR**

(30) Priorité: **06.05.2002 FR 0205622**

(43) Date de publication de la demande:
**12.11.2003 Bulletin 2003/46**

(73) Titulaire: **MBDA France**
**75116 Paris (FR)**

(72) Inventeurs:
• **Boubal, Michel**
**18000 Bourges (FR)**
• **Gevin, Olivier**
**75015 Paris (FR)**

(74) Mandataire: **Hauer, Bernard**
**Cabinet Bonnétat**
**29, Rue de Saint-Pétersbourg**
**75008 Paris (FR)**

(56) Documents cités:
**EP-A- 1 065 809**        **FR-A- 2 753 796**
**US-A- 5 376 813**        **US-A1- 2002 024 058**

• **ORLY YADID-PECHT: "WIDE-DYNAMIC-RANGE SENSORS" OPTICAL ENGINEERING, SOC. OF PHOTO-OPTICAL INSTRUMENTATION ENGINEERS. BELLINGHAM, US, vol. 38, no. 10, octobre 1999 (1999-10), pages 1650-1660, XP000859855 ISSN: 0091-3286**

## Description

La présente invention concerne une cellule de photodétection et un détecteur d'impulsion laser muni d'une telle cellule de photodétection, ainsi qu'un dispositif de détection d'impulsion laser comprenant une matrice de détecteurs de ce type.

Bien que non exclusivement, ledit dispositif de détection est destiné plus particulièrement à détecter une impulsion laser de durée très courte (par exemple 20 ns) qui est émise dans un environnement lumineux ambiant d'éclairement variable, à une fréquence prédéterminée (par exemple 10 Hz). A titre d'illustration, l'impulsion laser à détecter peut être émise par une source laser qui est pointée sur une cible, par exemple un char, pour la désigner afin qu'elle puisse être localisée par un système d'arme, tel qu'un missile, qui est équipé dudit dispositif de détection et qui est destiné à détruire cette cible. A cet effet, ledit dispositif de détection d'impulsion laser est par exemple associé à l'autodirecteur du missile, est agencé à poste fixe sur ledit missile et observe l'espace vers l'avant dudit missile. Les informations relatives à la localisation de la cible, qui sont engendrées par ce dispositif de détection, sont fournies à l'autodirecteur qui les utilise pour guider le missile sur la cible.

Un inconvénient important concernant l'utilisation d'un tel dispositif de détection réside dans la présence, en plus des impulsions laser de faible énergie et de courte durée que l'on souhaite détecter, de nombreux éclairements notamment solaires qui forment un bruit de fond lumineux, rendant souvent très difficile la détection desdites impulsions laser recherchées.

Le brevet US 5 376 813 décrit une cellule de photodétection comprenant un photocapteur et un moyen de traitement du courant électrique engendré par le photocapteur.

Par le brevet FR-2 753 796, on connaît un détecteur photosensible pour la détection d'éclats lumineux, ce détecteur photosensible comportant :

- une diode photosensible susceptible de transformer l'énergie lumineuse reçue en un courant électrique ou signal électrique ; et
- un moyen de traitement des signaux électriques engendrés par ladite diode photosensible, ledit moyen de traitement comprenant un circuit électrique dérivateur qui :

    . d'une part, renforce les signaux électriques présentant un temps de montée rapide et correspondant à un éclat lumineux recherché reçu par la diode photosensible ; et
    . d'autre part, atténue les signaux électriques correspondant à des illuminations plus lentement variables en intensité, de ladite diode photosensible.

Ce détecteur photosensible permet donc de mettre en évidence un éclat lumineux par rapport au bruit de fond lumineux.

Toutefois, lorsqu'on désire réaliser un détecteur photosensible de ce type, pour une application telle que celle précitée, on se heurte à plusieurs contraintes, et notamment :

- une contrainte de taille. Le détecteur doit en effet présenter une taille très réduite, par exemple 70 $\mu$m x 70 $\mu$m ;
- une contrainte de coût. Pour être rentable, le détecteur doit présenter un coût de fabrication très faible ; et
- une contrainte technique. Le détecteur doit pouvoir détecter et extraire du fond lumineux une impulsion laser de courte durée (par exemple 20 ns) et de très faible énergie (par exemple $10^{-13}$ J).

La présente invention a pour objet de remédier à ces contraintes. Elle concerne une cellule de photodétection telle que définie dans la revendication 1, de coût réduit, permettant de détecter de façon particulièrement efficace une impulsion laser de durée très courte et de faible énergie qui est émise, dans un environnement lumineux ambiant, d'éclairement variable.

A cet effet, selon l'invention, ladite cellule de photodétection réalisée sous forme d'un circuit intégré en technologie CMOS et comportant un photocapteur qui est susceptible de transformer une énergie lumineuse reçue en un courant électrique et un moyen de traitement du courant électrique engendré par ledit photocapteur, est remarquable en ce que ledit moyen de traitement comporte un amplificateur inverseur cascodé, rebouclé par une contre-réaction de type suiveur lent, qui est alimentée par le courant électrique engendré par ledit photocapteur.

Ainsi, on obtient une cellule de photodétection qui est particulièrement efficace pour isoler (et amplifier) le courant électrique relatif à une impulsion lumineuse de courte durée, par rapport au courant électrique global qui est engendré par ledit photocapteur et qui comprend également le fond lumineux, de manière à pouvoir ensuite traiter le signal correspondant à cette impulsion lumineuse.

En outre, comme on le verra plus en détail ci-dessous, ladite cellule de photodétection présente de nombreux avantages supplémentaires. Elle est notamment compacte, simple à réaliser et peu sensible aux dispersions technologiques.

Par ailleurs, ladite cellule photoélectrique présente un coût réduit, notamment en raison de sa réalisation sous forme de circuit intégré par un procédé de fabrication CMOS usuel.

Selon l'invention, ladite contre-réaction comprend un suiveur (de type lent) comportant plusieurs transistors NMOS identiques, montés en série et alimentés par le courant électrique engendré par ledit photocapteur. De préférence, ledit suiveur comporte deux transistors NMOS.

En outre, dans un mode de réalisation préféré, ledit photocapteur est une photodiode de type caisson-substrat, qui est particulièrement appropriée à la détection d'une impulsion laser infrarouge.

La présente invention comporte également un détecteur d'impulsion laser qui comporte une cellule de photodétection telle que celle décrite ci-dessus.

Avantageusement, ledit détecteur comporte de plus :

- un filtre passe-haut à amplificateur inverseur rebouclé ; et/ou
- un comparateur à paire différentielle PMOS à charge NMOS, pour comparer la réponse de la cellule de photodétection à un seuil réglable ; et/ou
- une cellule de mémorisation.

Par ailleurs, la présente invention concerne également un dispositif de détection d'impulsion laser, qui est remarquable en ce qu'il comporte une pluralité de détecteurs d'impulsion laser du type précité, qui sont formés sur un circuit intégré et qui sont agencés en lignes et en colonnes sous forme de matrice.

Les figures du dessin annexé feront bien comprendre comment l'invention peut être réalisée. Sur ces figures, des références identiques désignent des éléments semblables.

La figure 1 représente schématiquement une cellule de photodétection conforme à l'invention.

Les figures 2 et 3 montrent, de façon schématique, respectivement un amplificateur et un suiveur de la cellule de photodétection de la figure 1.

La figure 4 représente schématiquement un détecteur d'impulsion laser conforme à l'invention.

La figure 5 montre, schématiquement et partiellement, un dispositif de détection d'impulsion laser conforme à l'invention.

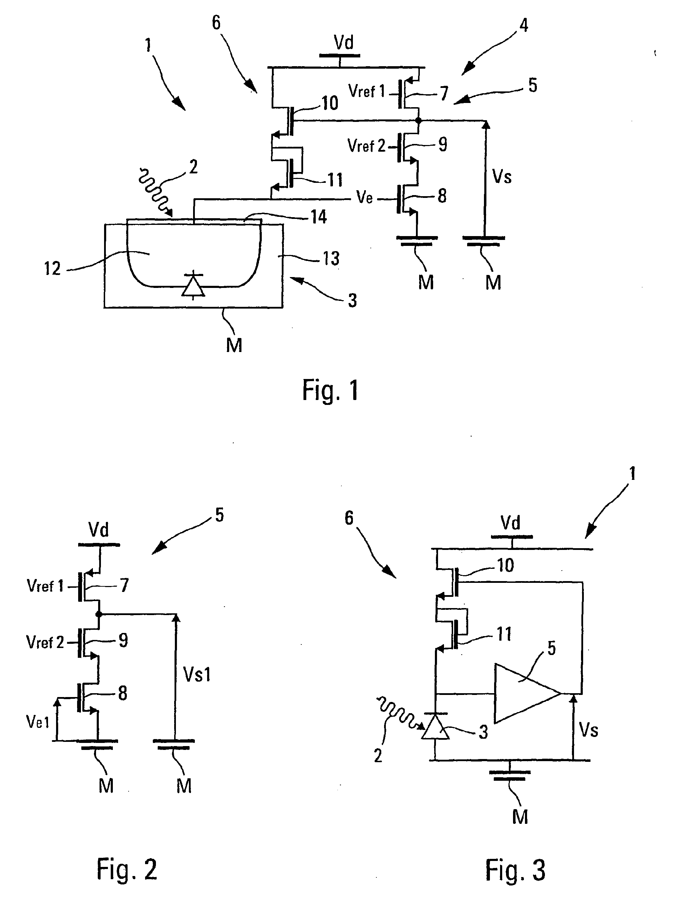

La cellule de photodétection 1 conforme à l'invention et représentée sur la figure 1 est destinée plus particulièrement à détecter une impulsion laser 2 de très courte durée (par exemple 20 ns) et de faible énergie (par exemple $10^{-13}$ J), qui est émise dans un environnement lumineux ambiant d'éclairement variable, à une fréquence prédéterminée (par exemple 10 Hz).

Ladite cellule de photodétection 1 qui est réalisée sous forme d'un circuit intégré en technologie CMOS est du type comportant un photocapteur 3, qui est susceptible de transformer une énergie lumineuse reçue en un courant électrique et un moyen 4 de traitement du courant électrique engendré par ledit photocapteur 3.

Selon l'invention, ledit moyen de traitement 4 comporte un amplificateur inverseur cascodé 5, rebouclé par une contre-réaction 6 de type suiveur lent, qui est alimentée par le courant électrique engendré par ledit photocapteur 3. Ce moyen de traitement 4 délivre à sa sortie une tension Vs, en fonction de la tension d'entrée Ve qui lui est appliquée.

L'amplificateur inverseur cascodé 5 comporte, comme représenté sur la figure 2, entre un transistor 7 de charge (à la tension de charge Vd, avec une tension de référence Vref1) et un transistor 8 de signal (recevant comme signal d'entrée une tension Ve1) relié à la masse M du circuit, un étage de type grille commune composé d'un transistor 9 de même type que le transistor 8 [par exemple un transistor NMOS, c'est-à-dire un semi-conducteur à oxyde de métal à canal N], dont la grille est polarisée à une tension de référence Vref2. La tension de sortie de cet amplificateur 5 est notée Vs1.

La contre-réaction 6 comprend, comme représenté sur la figure 3, un transistor 10 sur la grille duquel on vient reboucler le système et au moins un transistor 11, de préférence identique au transistor 10, qui est monté en série avec ledit transistor 10. Les différents transistors 10, 11 sont alimentés par le courant électrique engendré par le photocapteur 3. ce suiveur de type lent peut comporter une pluralité de transistors NMOS. Dans un mode de réalisation préféré, il comporte uniquement deux transistors 10 et 11, comme représenté sur les figures 1 et 3.

On notera que pour des variations lentes du courant alimentant la contre-réaction 6, l'amplificateur 5 est contre-réactionné alors que, pour une variation rapide, il fonctionne en boucle ouverte. La cellule de photodétection 1 se caractérise donc par un gain dynamique et un gain statique tels que :

- pour le gain dynamique (réponse de la cellule de photodétection 1 à une impulsion de courant iph engendrée par le photocapteur 3 suite à son éclairement par une impulsion laser 2), sur quasiment toute la gamme de courant de fond auquel se superpose l'impulsion laser 2, la réponse de la cellule 1 vaut, si le gain en boucle ouverte de l'amplificateur 5 est indépendant de ce courant de fond :

$$Zac = \frac{Vs}{iph} = \frac{A.t}{C}$$

avec :

    . t, la durée de l'impulsion 2 ;
    . A, le gain de l'amplificateur 5 en boucle ouverte :

    . C, la capacité du photocapteur 3 ; et
    . Vs, l'amplitude de la réponse en sortie de la cellule 1 ;

- pour le gain statique, l'évolution du courant traversant le photocapteur de i0 à i1 modifie la tension continue en sortie de la cellule 1 de V0 à V1 :

$$V1 = V0 + nVt \frac{A}{A+1} \ln \frac{i1}{i0}$$

avec :

. n, le nombre de transistors dans la boucle (deux dans l'exemple des figures 1, 3 et 4) ; et
. Vt, le potentiel thermodynamique.

Ceci correspond à la réponse non amplifiée d'un détecteur logarithmique à un courant lent. On bénéficie de la grande dynamique d'entrée qui fait l'intérêt de ce photodétecteur, de manière quasiment indépendante du gain A de l'amplificateur.

Par ailleurs, dans le mode de réalisation préféré représenté sur la figure 1, le photocapteur 3 est une photodiode de type caisson profond comprenant un caisson 12 de type N qui est formé dans un substrat 13 de type P et qui est muni d'une surface d'éclairement 14. Un tel photocapteur 13 est particulièrement approprié à la détection d'une impulsion laser infrarouge.

On notera que la cellule de photodétection 1 conforme à l'invention est capable de détecter une impulsion lumineuse (laser) de 20 ns inférieure à 0.1 $\mu$W, ce qui correspond à une énergie de l'ordre du femto-Joule. En plus, sa sensibilité est quasiment indépendante du niveau du fond lumineux continu, auquel se superpose l'impulsion lumineuse 2, et ce sur une dynamique du fond de 6 décades.

Ainsi, grâce à l'invention, on obtient une cellule de photodétection 1 qui est particulièrement efficace pour isoler (et amplifier) le courant électrique relatif à une impulsion lumineuse 2 de courte durée, par rapport au courant électrique global qui est engendré par ledit photocapteur 3 et qui comprend également le fond lumineux, de manière à pouvoir traiter le signal correspondant à cette impulsion lumineuse 2.

En outre, ladite cellule de photodétection 1 présente de nombreux avantages supplémentaires. Elle est notamment compacte, simple à réaliser, peu sensible aux dispersions technologiques, et de plus présente un coût réduit, notamment en raison de sa réalisation sous forme de circuit intégré dans une technologie CMOS usuelle.

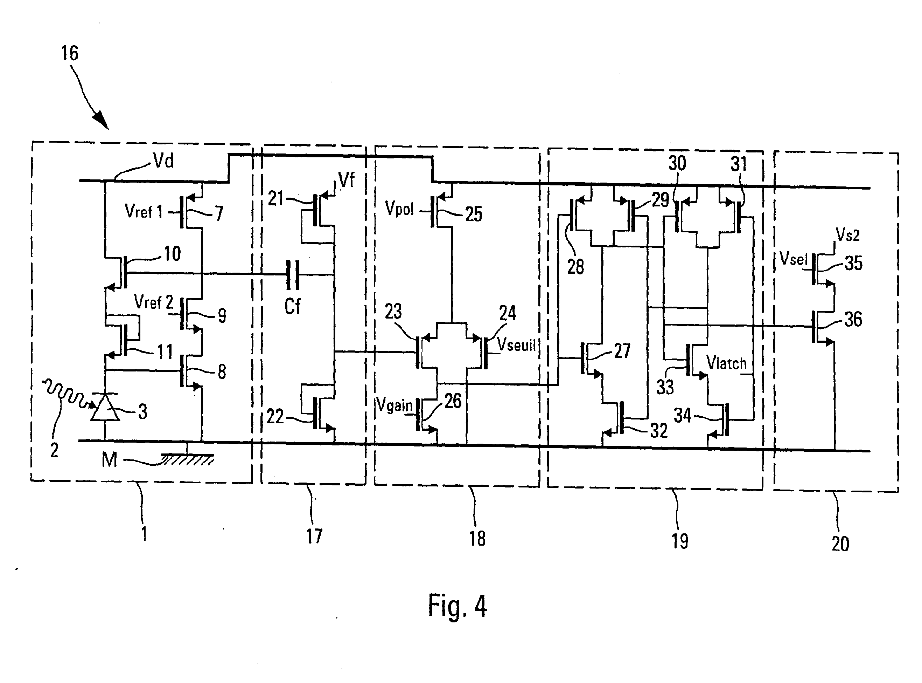

Ladite cellule de photodétection 1 peut être intégrée dans un détecteur 16 d'impulsion laser représenté selon un mode de réalisation préféré sur la figure 4.

Ledit détecteur 16 comporte, en plus de ladite cellule de photodétection 1, successivement :

- un moyen de filtrage 17 ;
- un comparateur 18 ;
- une cellule de mémorisation 19 ; et
- un moyen 20 de sélection de ligne.

Bien que sa sensibilité soit indépendante du niveau du fond lumineux, la cellule de photodétection 1 ne filtre pas la composante lente du fond. Le moyen de filtrage 17 qui comprend un filtre passe-haut a pour objet de réaliser ce filtrage.

Ledit moyen de filtrage 17 est un filtre passe-haut à amplificateur inverseur rebouclé comportant, en plus d'une capacité Cf, deux transistors 21 et 22 qui constituent l'amplificateur et qui sont montés en diode. La résistance équivalente est inversement proportionnelle à la somme de leur transconductance, et les capacités parasites apportées par l'amplificateur à la sortie de la cellule sont principalement les capacités grille-source des transistors 21 et 22. Le transistor 21 est soumis à une tension de polarisation Vf.

On notera en outre que la valeur minimale de la capacité Cf est imposée par la taille des transistors 21 et 22 du moyen de filtrage 17 et la valeur maximale dépend de la surface de silicium que l'on veut utiliser : les capacités sont réalisées à partir de la superposition de couches de polysilicium 1 et 2 par exemple. Une capacité de 180 fF occupe une surface de l'ordre de 100 $\mu$m$^2$.

Par ailleurs, le comparateur 18 a pour objet de réduire les détections parasites en élevant le seuil de comparaison, lorsque la puissance de l'énergie lumineuse est importante. A cet effet, ledit comparateur 18 est un comparateur à paire différentielle PMOS (transistors 23 et 24) [PMOS : semi-conducteur à oxyde de métal à canal P] à charge NMOS (transistors 25 et 26), pour comparer le signal issu du moyen de filtrage 17 à un seuil réglable (Vseuil).

Le transistor 25 (soumis à une tension de polarisation Vpol) est utilisé comme source de courant et le transistor 26 est une résistance commandée en tension (Vgain).

Quant à la cellule de mémorisation 19, elle est réalisée sous forme d'une mémoire usuelle de type "latch", comportant des transistors 27 à 34 et associée à une tension de commande Vlatch. Cette cellule de mémorisation 19 a pour objet de mémoriser le passage du comparateur 18 par un niveau bas correspondant à la détection d'une impulsion lumineuse.

Par ailleurs, le moyen 20 de sélection de ligne comporte deux transistors 35 et 36 et est associé à une tension de commande Vsel. Ledit moyen 20 délivre donc le signal de sortie (Vs2) dudit détecteur 16 d'impulsion laser.

Par conséquent, le détecteur 16 comporte cinq tensions de polarisation (Vref1, Vref2, Vf, Vgain, Vpol) et trois tensions de commande (Vseuil, Vlatch, Vsel).

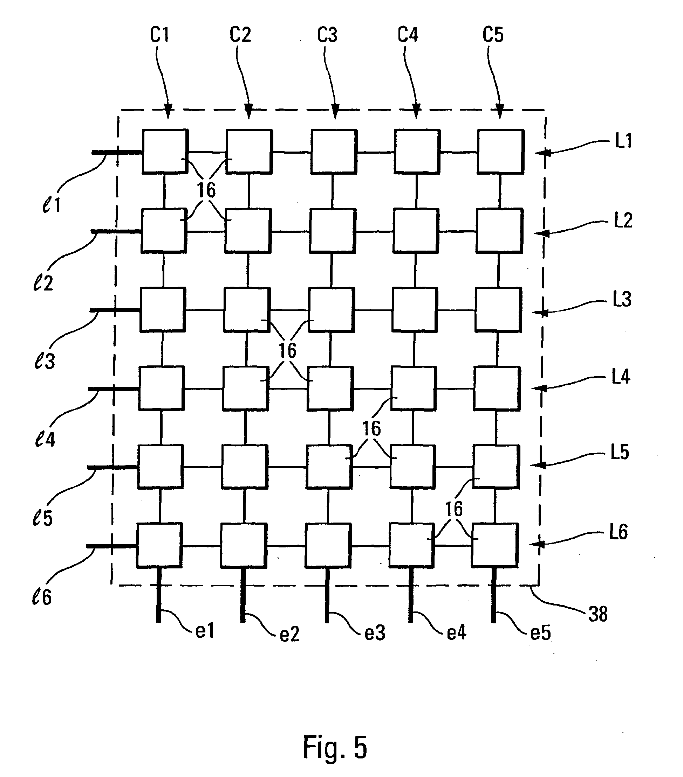

Un tel détecteur 16 peut faire partie d'un dispositif 38 de détection d'impulsion laser. A cet effet, ce dispositif 38 comporte, tel que représenté partiellement sur la figure 5, une pluralité de détecteurs 16 d'impulsion laser, tels que celui précité, qui sont formés sur un circuit intégré et qui sont agencés en lignes L1, L2, L3, L4, L5, L6 (avec des liaisons de sortie $\ell$1 à $\ell$6) et en colonnes C1, C2, C3, C4, C5 (avec des liaisons de sortie e1 à e5), sous forme de matrice.

**Revendications**

1. Cellule de photodétection réalisée sous forme d'un circuit intégré en technologie CMOS et comportant un photocapteur (3) qui est susceptible de transformer une énergie lumineuse reçue en un courant électrique et un moyen de traitement (4) du courant électrique engendré par ledit photocapteur (3), **caractérisée en ce que** ledit moyen de traitement (4) comporte un amplificateur inverseur cascodé (5), rebouclé par une contre-réaction (6) de type suiveur lent, qui comprend un suiveur à transistors NMOS identiques (10, 11), montés en série et alimentés par le courant électrique engendré par ledit photocapteur (3).

2. Cellule de photodétection selon la revendication 1, **caractérisée en ce que** ledit suiveur comporte deux transistors NMOS (10, 11).

3. Cellule de photodétection selon l'une des revendications 1 et 2, **caractérisée en ce que** ledit photocapteur (3) est une photodiode de type caisson-substrat.

4. Détecteur d'impulsion laser, **caractérisé en ce qu'**il comporte une cellule de photodétection (1) telle que celle spécifiée sous l'une quelconque des revendications 1 à 3.

5. Détecteur selon la revendication 4, **caractérisé en ce qu'**il comporte de plus un filtre passe-haut (17) à amplificateur inverseur rebouclé.

6. Détecteur selon l'une des revendications 4 et 5, **caractérisé en ce qu'**il comporte de plus un comparateur (18) à paire différentielle PMOS à charge NMOS, pour comparer la réponse de la cellule de photodétection (1) à un seuil réglable.

7. Détecteur selon l'une des revendications 4 à 6, **caractérisé en ce qu'**il comporte de plus une cellule de mémorisation (19).

8. Dispositif de détection d'impulsion laser, **caractérisé en ce qu'**il comporte une pluralité de détecteurs (1) d'impulsion laser, tels que celui spécifié sous l'une quelconque des revendications 4 à 7, qui sont formés sur un circuit intégré et qui sont agencés en lignes (L1 à L6) et en colonnes (C1 à C5) sous forme de matrice.

**Claims**

1. A photodetection cell embodied in the form of a CMOS technology integrated circuit and comprising a photosensor (3) which is able to transform luminous energy received into an electric current and a means (4) for processing the electric current generated by said photosensor (3), **characterized in that** said processing means (4) comprises a cascoded inverting amplifier (5), looped back through a feedback (6) of slow follower type, which comprises a follower having identical NMOS transistors (10, 11) arranged in series and supplied by the electric current generated-by said photosensor (3).

2. The photodetection cell as claimed in claim 1, **characterized in that** said follower comprises two NMOS transistors (10, 11).

3. The photodetection cell as claimed in one of claims 1 and 2, **characterized in that** said photosensor (3) is a well/substrate type photodiode.

4. A laser pulse detector, **characterized in that** it comprises a photodetection cell (1) as specified under any one of claims 1 to 3.

5. The detector as claimed in claim 4, **characterized in that** it furthermore comprises a high-pass filter (17) with feedback inverting amplifier.

6. The detector as claimed in one of claims 4 and 5, **characterized in that** it furthermore comprises a comparator (18) with PMOS differential pair with NMOS load, for comparing the response of the photodetection cell (1) with an adjustable threshold.

7. The detector as claimed in one of claims 4 to 6, **characterized in that** it furthermore comprises a storage cell (19).

8. A laser pulse detection device, **characterized in that** it comprises a plurality of laser pulse detectors (1), such as the one specified under any one of claims 4 to 7, which are formed on an integrated circuit and which are disposed in rows (L1 to L6) and columns (C1 to C5) in matrix form.

**Patentansprüche**

1. Photodetektorzelle, die in der Form eines integrierten Schaltkreises in CMOS-Technologie ausgebildet ist und Folgendes umfasst: einen Photosensor (3), der geeignet ist, eine empfangene Lichtenergie in elektrischen Strom umzuwandeln, und ein Mittel zur Verarbeitung (4) des elektrischen Stroms, der durch den Photosensor (3) erzeugt wurde, **dadurch gekennzeichnet, dass** das Verarbeitungsmittel (4) einen kaskodierten invertierenden Verstärker (5) umfasst, der durch eine Gegenkopplung (6) vom Typ langsamer Folger zur Schleife geschaltet ist, der einen Folger mit identischen NMOS-Transistoren (10, 11) umfasst, die in Serie geschaltet sind und durch den elektrischen Strom gespeist werden, der durch den Photosensor (3) erzeugt wird.

2. Photodetektorzelle nach Anspruch 1,
   **dadurch gekennzeichnet, dass** der Folger zwei NMOS-Transistoren (10, 11) umfasst.

3. Photodetektorzelle nach einem der Ansprüche 1 und 2,
   **dadurch gekennzeichnet, dass** der Photosensor (3) eine Photodiode vom Typ Wanne-Substrat ist.

4. Laserimpulsdetektor,
   **dadurch gekennzeichnet, dass** er eine Photodetektorzelle (1) umfasst, wie sie unter einem der Ansprüche 1 bis 3 spezifiziert wurde.

5. Detektor nach Anspruch 4,
   **dadurch gekennzeichnet, dass** er darüber hinaus ein Hochpassfilter (17) mit zur Schleife geschaltetem invertierendem Verstärker umfasst.

6. Detektor nach einem der Ansprüche 4 und 5,
   **dadurch gekennzeichnet, dass** er darüber hinaus einen Komparator (18) mit PMOS-Differentialpaar mit NMOS-Last umfasst, um die Reaktion der Photodetektorzelle (1) mit einer einstellbaren Schwelle zu vergleichen.

7. Detektor nach einem der Ansprüche 4 bis 6,
   **dadurch gekennzeichnet, dass** er darüber hinaus eine Speicherzelle (19) umfasst.

8. Laserimpulsdetektor-Vorrichtung,
   **dadurch gekennzeichnet, dass** sie eine Vielzahl von Laserimpulsdetektoren (1) von dem in einem der Ansprüche 4 bis 7 spezifizierten Typ umfasst, die in einem integrierten Schaltkreis gebildet sind und in Form einer Matrix in Zeilen (L1 bis L6) und Spalten (C1 bis C5) angeordnet sind.

Fig. 1

Fig. 2

Fig. 3

Fig. 4

EP 1 361 613 B1

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5376813 A

- FR 2753796